# EUROPEAN PATENT SPECIFICATION

(11) **EP 3 715 887 B1**
(45) Date of publication and mention of the grant of the patent: **10.07.2024**
(21) Application number: 20166371.3
(22) Date of filing: 27.03.2020
(51) Int. Cl.: G01R 31/28, H05K 13/04

(54) **INSPECTING DEVICE**
INSPEKTIONSVORRICHTUNG
DISPOSITIF D'INSPECTION

(30) Priority: 29.03.2019 JP 2019068625
(43) Date of publication of application: 30.09.2020
(73) Proprietor: Sintokogio, Ltd., Aichi 4506424 (JP)
(72) Inventor: TSUNODA, Ryoichi, Oharu-cho, Ama-gun Aichi 4901144 (JP); HAMADA, Takayuki, Oharu-cho, Ama-gun Aichi 4901144 (JP)
(74) Representative: Bittner, Thomas L.

(56) References cited:
- EP-A2- 0 821 549
- EP-A2- 0 933 985
- EP-A2- 1 032 251
- EP-A2- 1 154 680
- WO-A1-2008/102592
- JP-A- H09 257 873
- JP-A- S61 293 749
- JP-B2- 5 160 819
- US-A- 5 894 217
- US-A1- 2001 047 586

## Description

### Technical Field

The present invention relates to an inspecting device which inspects a device such as a semiconductor device. In particular, the present invention relates to an inspecting device which inspects a device in each of two or more environments that are different in condition.

### Background Art

In an inspection of a semiconductor device, it is sometimes required to carry out a static characteristic test and a dynamic characteristic test. Patent Literature 1 The document JP 2016-206150 A discloses an inspecting device which carries out such tests. Further, in an inspection of a semiconductor device, it is sometimes required to carry out tests in each of a room-temperature environment and a high-temperature environment. Documents JP S58-39021 A and JP H04-23446 A each disclose an inspecting device which carries out such tests.

Document US 5 894 217 A discloses a test handler with a turn table having a plurality of openings each of which is equally distanced from the other, and at least one of the openings is positioned right above a test socket provided on the IC tester, a plurality of carrier modules attached to the corresponding openings of the turn table where each of the carrier modules has a center opening to receive an IC device to be tested, and a press mechanism provided above the test socket of the IC tester to press the IC device in the carrier module downward so that pins of the IC device contact the test socket. The center opening of the carrier module has tapered walls at the periphery thereof where an upper portion of the center opening is wider than a lower portion of the center opening, and a plurality of guide slits are provided on the tapered walls of the center opening for guiding the pins of the IC device therethrough when the IC device is pressed by the press mechanism.

Document JP H09-257873 A relates to a heating device for an IC device, comprising first, second and third heater tables each directly heating the device by a heater by gradually raising the heating temperature and a working table. A heating section on a position in the first heater table, heater sections on respective positions in the second and third table and a device setting section on a position in the working table are placed on a locus of an identical circle having an angle of 90 degrees between the respective adjacent two of them. The device is held by vacuum suction and sequentially loaded on each of the heater tables and working table to move it from the former to the latter by a device moving/loading means capable of rotating and vertically moving. A rotational center of the device moving/loading means is on the center of the circle. The device moving/loading means comprises four arms with an angle of degrees between the respective adjacent two of them and a suction pad is provided to each of the arms at a position of which distance from the rotational center corresponds to a radius of the circle so that four devices can be simultaneously held and moved.

### Summary of Invention

### Technical Problem

In order to efficiently carry out an inspection of a semiconductor device, it is preferable to carry out a static characteristic test and a dynamic characteristic test on an index table which conveys the semiconductor device. However, in a case where the semiconductor device is directly placed on the index table and these tests are carried out, the index table may be damaged in a case where the semiconductor device is a defective. Therefore, it is preferable to carry out these tests in a state where the semiconductor device is placed on the index table via a mount that is replaceable.

However, in this case, a mechanism for handling the semiconductor device and a mechanism for handling the mount are needed. Accordingly, an increase in size and an increase in cost of an inspecting device are inevitable.

Note that problems which arise in a case where a semiconductor device is tested have been described. However, similar problems can arise also in a case where a device other than the semiconductor device is tested. That is, it is possible to generalize the above problems as problems which can arise in a case where any device is tested.

An object of the present invention is to reduce a size and lower a cost of an inspecting device that includes an index table on which a device is placed via a replaceable mount.

### Solution to Problem

In order to attain the above object, an inspecting device in accordance with appended claim 1 has been provided.

### Advantageous Effects of Invention

According to the claimed invention, it is possible to reduce a size and lower a cost of an inspecting device that includes an index table on which a device is placed via a replaceable mount.

### Brief Description of Drawings

- Fig. 1: is a perspective view illustrating an outline of a configuration of an inspecting device in accordance with an embodiment of the present invention.
- Fig. 2: is a plan view illustrating a conveyance route, along which a semiconductor device is conveyed, in the inspecting device illustrated in Fig. 1.
- Fig. 3: is a flow diagram illustrating a flow of a method of inspecting a semiconductor device with use of the inspecting device illustrated in Fig. 1.
- Fig. 4: is a plan view of a first index table included in the inspecting device illustrated in Fig. 1.
- Fig. 5: is a partial cross-sectional view illustrating, in detail, a device placement region and a region around the device placement region of the first index table.
- Fig. 6: is a plan view of a second index table included in the inspecting device illustrated in Fig. 1.
- Fig. 7: is a partial cross-sectional view illustrating, in detail, a device placement region and a region around the device placement region of the second index table.
- Fig. 8: is a plan view of an arm included in the inspecting device illustrated in Fig. 1.
- Fig. 9: is a side view of a device sucking head included in the arm included in the inspecting device illustrated in Fig. 1.
- Fig. 10: is a side view of a mount sucking head included in the arm included in the inspecting device illustrated in Fig. 1.
- Fig. 11: is a schematic view illustrating a flow of a method of replacing a mount put on the first index table included in the inspecting device illustrated in Fig. 1.
- Fig. 12: is a schematic view illustrating a flow of a method of replacing a mount put on the second index table included in the inspecting device illustrated in Fig. 1.

### Description of Embodiments

### [Outline of configuration of inspecting device]

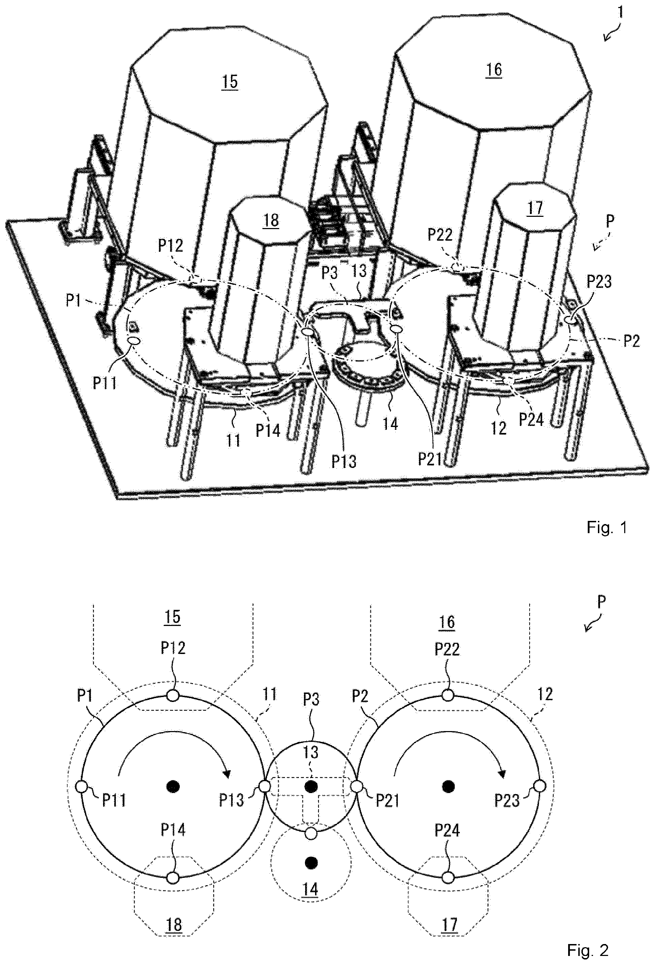

An outline of a configuration of an inspecting device 1 in accordance with an embodiment of the present invention will be described with reference to Fig. 1. Fig. 1 is a perspective view illustrating the outline of the configuration of the inspecting device 1.

The inspecting device 1 is a device for carrying out, with respect to a semiconductor device (an example of a "device" in the Claims), a static characteristic test and a dynamic characteristic test in each of a room-temperature environment (an example of a "first environment" in the Claims) and a high-temperature environment (an example of a "second environment" in the Claims). Note, here, that the high-temperature environment refers to an environment in which a temperature is higher than that in the room-temperature environment.

As illustrated in Fig. 1, the inspecting device 1 includes a first index table 11, a second index table 12, an arm 13, a mount collecting and supplying unit 14, a first testing device 15, a second testing device 16, a third testing device 17, and a fourth testing device 18.

The first index table 11 is a device for conveying the semiconductor device placed thereon along a first within-table conveyance route P1 having a circular shape. The first index table 11 has device placement regions in each of which a device is placed via a mount that is replaceable. On the first within-table conveyance route P1, first through fourth positions P11 through P14 are set at regular intervals. In particular, the third position P13 is set at a position on the first within-table conveyance route P1 which position is the closest to the second index table 12. The first index table 11 is rotated 90 degrees clockwise as viewed from above, thereby (1) conveying the semiconductor device at the first position P11 to the second position P12, (2) conveying the semiconductor device at the second position P12 to the third position P13, (3) conveying the semiconductor device at the third position P13 to the fourth position P14, and (4) conveying the semiconductor device at the fourth position P14 to the first position P11.

In the present embodiment, the first index table 11 functions as a room-temperature test station for carrying out the static characteristic test and the dynamic characteristic test in the room-temperature environment. Examples of the room-temperature environment include an environment in which it is possible to set a temperature of the semiconductor device to not lower than 20°C and not higher than 30°C. The inspecting device 1 is often installed inside a clean room. A room temperature inside the clean room is set to 25°C, for example. An actual room temperature is often not lower than 20°C and not higher than 30°C. As a result, the temperature of the semiconductor device placed on the first index table 11 is also not lower than 20°C and not higher than 30°C. The first index table 11 will be later described in detail with reference to other drawings.

The second index table 12 is a device for conveying the semiconductor device placed thereon along a second within-table conveyance route P2 having a circular shape. The second index table 12 has (i) device placement regions in each of which a device is placed via a mount that is replaceable and (ii) mount placement regions in each of which a spare mount is placed. On the second within-table conveyance route P2, first through fourth positions P21 through P24 are set. In particular, the first position P21 is set at a position on the second within-table conveyance route P2 which position is the closest to the first index table 11. The second index table 12 is rotated 90 degrees clockwise as viewed from above, thereby (1) conveying the semiconductor device at the first position P21 to the second position P22, (2) conveying the semiconductor device at the second position P22 to the third position P23, (3) conveying the semiconductor device at the third position P23 to the fourth position P24, and (4) conveying the semiconductor device at the fourth position P24 to the first position P21.

In the present embodiment, the second index table 12 functions as a high-temperature test station for carrying out the static characteristic test and the dynamic characteristic test in the high-temperature environment. Examples of the high-temperature environment include an environment in which it is possible to set the temperature of the semiconductor device to not lower than 50°C and not higher than 300°C. The second index table 12 will be later described in detail with reference to other drawings.

The arm 13 is a T-shaped rotary arm, and has a first device sucking head 13a, a second device sucking head 13b, and a mount sucking head 13c. The arm 13 carries out a device transferring operation with use of the first and second device sucking heads 13a and 13b. Note, here, that the device transferring operation refers to an operation of concurrently (i) transferring the semiconductor device placed on the first index table 11 to the second index table 12 with use of one of the first and second device sucking heads 13a and 13b and (ii) transferring another semiconductor device placed on the second index table 12 to the first index table 11 with use of the other of the first and second device sucking heads 13a and 13b. Furthermore, the arm 13 carries out a device collecting operation with use of one of the first and second device sucking heads 13a and 13b. Note, here, that the device collecting operation refers to an operation of collecting, from the first index table 11 or the second index table 12, a device which has been found to be a defective in any test. Moreover, the arm 13 carries out a mount collecting operation with use of the mount sucking head 13c. Note, here, that the mount collecting operation refers to an operation of collecting, from the first index table 11 or the second index table 12, a mount on which a device that has been found to be a defective in any test is placed. The arm 13 also carries out a mount putting operation with use of the mount sucking head 13c. Note, here, that the mount putting operation refers to an operation of putting, on the first index table 11 or the second index table 12, a spare mount obtained from the second index table 12 or the mount collecting and supplying unit 14 (later described). The arm 13 will be later described in detail with reference to other drawings.

The mount collecting and supplying unit 14 is a unit for (i) collecting a mount on which a device that has been found to be a defective in any test is placed and (ii) supplying a spare mount with which the mount is to be replaced.

The first testing device 15 is a device for carrying out, with respect to the semiconductor device placed on the first index table 11, the dynamic characteristic test in the room-temperature environment. In the present embodiment, at the second position P12 on the first within-table conveyance route P1, the dynamic characteristic test is carried out with respect to the semiconductor device by the first testing device 15.

The second testing device 16 is a device for carrying out, with respect to the semiconductor device placed on the second index table 12, the dynamic characteristic test in the high-temperature environment. In the present embodiment, at the second position P22 on the second within-table conveyance route P2, the dynamic characteristic test is carried out with respect to the semiconductor device by the second testing device 16.

The third testing device 17 is a device for carrying out, with respect to the semiconductor device placed on the second index table 12, the static characteristic test in the high-temperature environment. In the present embodiment, at the fourth position P24 on the second within-table conveyance route P2, the static characteristic test is carried out with respect to the semiconductor device by the third testing device 17.

The fourth testing device 18 is a device for carrying out, with respect to the semiconductor device placed on the first index table 11, the static characteristic test in the room-temperature environment. In the present embodiment, at the fourth position P14 on the first within-table conveyance route P1, the static characteristic test is carried out with respect to the semiconductor device by the fourth testing device 18.

Note that each of the first through fourth testing devices 15 through 18 can be realized by a publicly known configuration (for example, the configuration disclosed in Patent Literature 1). Therefore, the first through fourth testing devices 15 through 18 will not be described herein in detail.

### [Conveyance route for semiconductor device]

A conveyance route P, along which the semiconductor device is conveyed, in the inspecting device 1 will be described with reference to Fig. 2. Fig. 2 is a plan view illustrating a configuration of the conveyance route P.

The conveyance route P includes the first within-table conveyance route P1, the second within-table conveyance route P2, and the between-table conveyance route P3. The first within-table conveyance route P1 is a conveyance route along which the semiconductor device is conveyed by the first index table 11. The second within-table conveyance route P2 is a conveyance route along which the semiconductor device is conveyed by the second index table 12. The between-table conveyance route P3 is a conveyance route along which the semiconductor device is conveyed (transferred) by the arm 13.

According to the inspecting device 1, the semiconductor device is conveyed as follows.

First, the semiconductor device which has not been inspected is supplied to the position P11 on the first within-table conveyance route P1 by a device supplying unit (not illustrated in Fig. 1).

Next, by the first index table 11, the semiconductor device supplied to the first position P11 on the first within-table conveyance route P1 is (1) conveyed from the first position P11 to the second position P12 and (2) conveyed from the second position P12 to the third position P13, along the first within-table conveyance route P1.

The semiconductor device conveyed to the third position P13 on the first within-table conveyance route P1 is then conveyed (transferred), by the arm 13, to the first position P21 on the second within-table conveyance route P2 along the between-table conveyance route P3.

Subsequently, by the second index table 12, the semiconductor device conveyed to the first position P21 on the second within-table conveyance route P2 is (1) conveyed from the first position P21 to the second position P22, (2) conveyed from the second position P22 to the third position P23, (3) conveyed from the third position P23 to the fourth position P24, and (4) conveyed from the fourth position P24 to the first position P21, along the second within-table conveyance route P2.

The semiconductor device conveyed to the first position P21 on the second within-table conveyance route P2 is then conveyed (transferred), by the arm 13, to the third position P13 on the first within-table conveyance route P1 along the between-table conveyance route P3.

Next, by the first index table 11, the semiconductor device conveyed to the third position P13 on the first within-table conveyance route P1 is (1) conveyed from the third position P13 to the fourth position P14 and (2) conveyed from the fourth position P14 to the first position P11, along the first within-table conveyance route P1.

Finally, the semiconductor device which has been inspected and which has been conveyed to the first position P11 on the first within-table conveyance route P1 is collected by a device collecting unit (not illustrated in Fig. 1).

According to the inspecting device 1, the dynamic characteristic test and the static characteristic test are carried out in each of the room-temperature environment and the high-temperature environment with respect to the semiconductor device conveyed as described above. First, at the second position P12 on the first within-table conveyance route P1, the dynamic characteristic test is carried out in the room-temperature environment by the first testing device 15. Next, at the second position P22 on the second within-table conveyance route P2, the dynamic characteristic test is carried out in the high-temperature environment by the second testing device 16. Subsequently, at the fourth position P24 on the second within-table conveyance route P2, the static characteristic test is carried out in the high-temperature environment by the third testing device 17. Finally, at the fourth position P14 on the first within-table conveyance route P1, the static characteristic test is carried out in the room-temperature environment by the fourth testing device 18.

A between-table conveyance route included in the conveyance route P illustrated in Fig. 2 is merely the between-table conveyance route P3. Furthermore, it is possible to make a length of the between-table conveyance route P3 shorter than a length of a between-table conveyance route along which a semiconductor device is transferred between shuttle tables. Therefore, it is possible to carry out the static characteristic test and the dynamic characteristic test in each of the room-temperature environment and the high-temperature environment, without causing an unnecessary increase in size of the inspecting device 1 and an unnecessary decrease in inspection speed.

Note that an imaging test can be carried out with respect to the semiconductor device at each of the first position P11 and the third position P13 on the first within-table conveyance route P1 and the first position P21 and the third position P23 on the second within-table conveyance route P2. For example, in the imaging test at the first position P11 on the first within-table conveyance route P1, a camera (not illustrated) captures an image of the semiconductor device placed on the first index table 11. Then, a controller (not illustrated) (1) calculates, based on the image thus captured, a difference between (i) a position at which the semiconductor device is actually placed and (ii) a predetermined reference position and (2) adjusts, based on the difference thus calculated, a position of a probe of the first testing device 15. This allows the first testing device 15 to suitably carry out the dynamic characteristic test, even in a case where the semiconductor device is placed at a position on the first index table 11 which position is deviated from the predetermined reference position. The imaging test can be similarly carried out also at each of the first position P21 on the second within-table conveyance route P2, the third position P23 on the second within-table conveyance route P2, and the third position P13 on the first within-table conveyance route P1. By carrying out the imaging test at each of these positions, it is possible to adjust a position of a probe of a corresponding one of the second testing device 16, the third testing device 17, and the fourth testing device 18, and accordingly possible to achieve an effect similar to that achieved by the above-described imaging test.

### [Flow of inspection method]

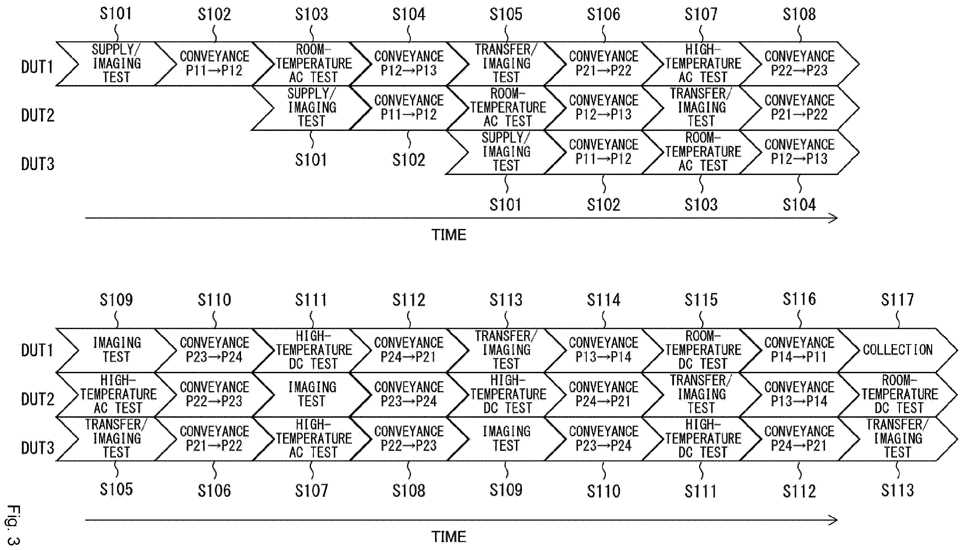

A flow of an inspection method S100 in which the inspecting device 1 is used will be described with reference to Fig. 3. Fig. 3 is a flow diagram illustrating a flow of the inspection method S100. Note that Fig. 3 illustrates, in a horizontal direction, a plurality of steps which are applied, in order, to a semiconductor device DUTi (i=1, 2, 3,...) and illustrates, in a vertical direction, a plurality of steps which are concurrently applied to a respective plurality of semiconductor devices DUT1, DUT2, DUT3,...

The inspection method S100 is an inspection method for testing a static characteristic and a dynamic characteristic of the semiconductor device in each of the room-temperature environment and the high-temperature environment with use of the above-described inspecting device 1. As illustrated in Fig. 3, the inspection method S100 includes a supply/imaging test step S101, a conveyance step S102, a room-temperature AC test step S103, a conveyance step S104, a transfer/imaging test step S105, a conveyance step S106, a high-temperature AC test step S107, a conveyance step S108, an imaging test step S109, a conveyance step S110, a high-temperature DC test step S111, a conveyance step S112, a transfer/imaging test step S113, a conveyance step S114, a room-temperature DC test step S115, a conveyance step S116, and a collection step S117.

The supply/imaging test step S101 is a step of supplying, at the first position P11 on the first within-table conveyance route P1, the semiconductor device DUT1 with use of the device supplying unit. Further, in this step, at the first position P11 on the first within-table conveyance route P1, the imaging test is carried out with respect to the semiconductor device DUT1 placed on the first index table 11, and the position of the probe of the first testing device 15 is adjusted based on a result of the imaging test.

The conveyance step S102 is a step of, by rotating the first index table 11 90 degrees, conveying the semiconductor device DUT1, placed on the first index table 11, from the first position P11 to the second position P12 along the first within-table conveyance route P1.

The room-temperature AC (dynamic characteristic) test step S103 is a step of carrying out, with respect to the semiconductor device DUT1 conveyed to the second position P12 on the first within-table conveyance route P1, the dynamic characteristic test in the room-temperature environment with use of the first testing device 15.

The conveyance step S104 is a step of, by rotating the first index table 11 90 degrees, conveying the semiconductor device DUT1, placed on the first index table 11, from the second position P12 to the third position P13 along the first within-table conveyance route P1.

The transfer/imaging test step S105 is a step of transferring, to the second index table 12 with use of the arm 13, the semiconductor device DUT1 conveyed to the third position P13 on the first within-table conveyance route P1. Further, in this step, at the first position P21 on the second within-table conveyance route P2, the imaging test is carried out with respect to the semiconductor device DUT1 transferred to the second index table 12. Based on a result of the imaging test, the position of the probe of the second testing device 16 is adjusted.

The conveyance step S106 is a step of, by rotating the second index table 12 90 degrees, conveying the semiconductor device DUT1, placed on the second index table 12, from the first position P21 to the second position P22 along the second within-table conveyance route P2.

The high-temperature AC test step S107 is a step of carrying out, with respect to the semiconductor device DUT1 conveyed to the second position P22 on the second within-table conveyance route P2, the dynamic characteristic test in the high-temperature environment with use of the second testing device 16.

The conveyance step S108 is a step of, by rotating the second index table 12 90 degrees, conveying the semiconductor device DUT1, placed on the second index table 12, from the second position P22 to the third position P23 along the second within-table conveyance route P2.

The imaging test step S109 is a step of, at the third position P23 on the second within-table conveyance route P2, carrying out the imaging test with respect to the semiconductor device DUT1 placed on the second index table 12. Further, in the imaging test step S109, the position of the probe of the third testing device 17 is adjusted based on a result of the imaging test.

The conveyance step S110 is a step of rotating the second index table 12 90 degrees. By carrying out the conveyance step S110, the semiconductor device DUT1, placed on the second index table 12, is conveyed from the third position P23 to the fourth position P24 along the second within-table conveyance route P2.

The high-temperature DC (static characteristic) test step S111 is a step of carrying out, with respect to the semiconductor device DUT1 conveyed to the fourth position P24 on the second within-table conveyance route P2, the static characteristic test in the high-temperature environment with use of the third testing device 17.

The conveyance step S112 is a step of, by rotating the second index table 12 90 degrees, conveying the semiconductor device DUT1, placed on the second index table 12, from the fourth position P24 to the first position P21 along the second within-table conveyance route P2.

The transfer/imaging test step S113 is a step of transferring, to the first index table 11 with use of the arm 13, the semiconductor device DUT1 conveyed to the first position P21 on the second within-table conveyance route P2. Further, in this step, at the third position P13 on the first within-table conveyance route P1, the imaging test is carried out with respect to the semiconductor device DUT1 transferred to the first index table 11. Based on a result of the imaging test, the position of the probe of the fourth testing device 18 is adjusted.

The conveyance step S114 is a step of rotating the first index table 11 90 degrees. By carrying out the conveyance step S114, the semiconductor device DUT1, placed on the first index table 11, is conveyed from the third position P13 to the fourth position P14 along the first within-table conveyance route P1.

The room-temperature DC test step S115 is a step of carrying out, with respect to the semiconductor device DUT1 conveyed to the fourth position P14 on the first within-table conveyance route P1, the static characteristic test in the room-temperature environment with use of the fourth testing device 18.

The conveyance step S116 is a step of rotating the first index table 11 90 degrees. By carrying out the conveyance step S116, the semiconductor device DUT1, placed on the first index table 11, is conveyed from the fourth position P14 to the first position P11 along the first within-table conveyance route P1.

The collection step S117 is a step of collecting, at the first position P11 on the first within-table conveyance route P1, the semiconductor device DUT1 with use of the device collecting unit.

Note that the above-described steps S101 through S117 are concurrently carried out with respect to the plurality of semiconductor devices DUT1, DUT2, DUT3,... For example, while the transfer/imaging test step S105 is being carried out with respect to the semiconductor device DUT1 which is the first semiconductor device, the room-temperature AC test step S103 is carried out with respect to the semiconductor device DUT2 which is the second semiconductor device, and the supply/imaging test step S101 is carried out with respect to the semiconductor device DUT3 which is the third semiconductor device. While the conveyance step S106 is being carried out with respect to the semiconductor device DUT1, the conveyance step S104 is carried out with respect to the semiconductor device DUT2, and the conveyance step S102 is carried out with respect to the semiconductor device DUT3.

### [Configuration of index table]

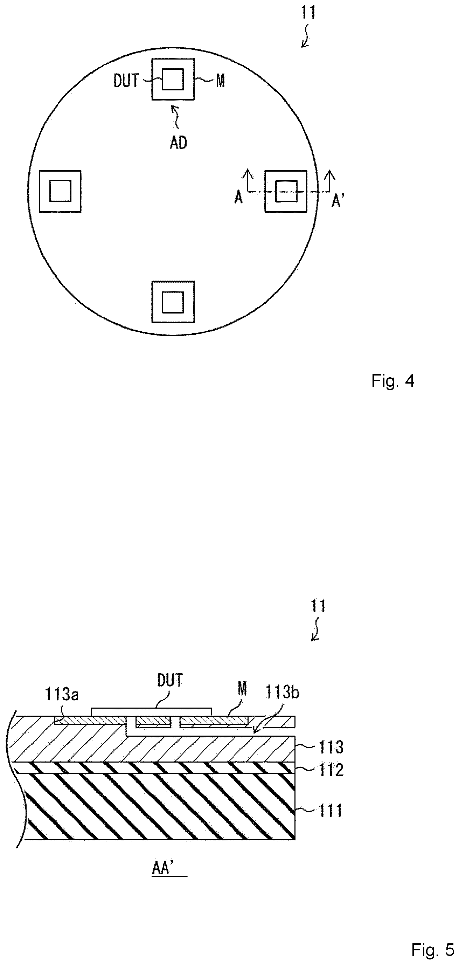

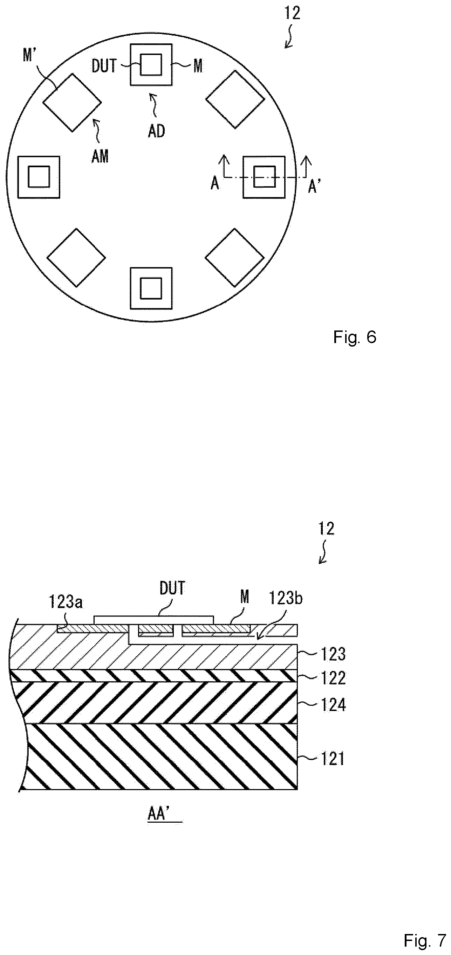

A configuration of the first index table 11 and a configuration of the second index table 12, which are included in the inspecting device 1, will be described with reference to Figs. 4 through 7. Fig. 4 is a plan view of the first index table 11. Fig. 5 is a partial cross-sectional view of the first index table 11. Fig. 6 is a plan view of the second index table 12. Fig. 7 is a partial cross-sectional view of the second index table 12.

As illustrated in Fig. 5, the first index table 11 is composed of a heat-resistant electrically insulating resin plate 111, a ceramic plate 112, and a stage block 113, which are stacked in this order. As illustrated in Figs. 4 and 5, the stage block 113 has, on an upper surface thereof, depressed parts 113a each of which functions as a device placement region AD. In each of the depressed parts 113a, a mount M is put, and a semiconductor device DUT is placed on the mount M. The mount M is a plate-shaped member made of a material having thermal conductivity and electrical conductivity (for example, metal). Further, the stage block 113 has, therein, air supply and exhaust passages 113b. Each of the air supply and exhaust passages 113b is, on one side, open in a corresponding one of the depressed parts 113a and communicated with through holes provided in the mount M. Each of the air supply and exhaust passages 113b is used as a flow passage through which air for sucking the semiconductor device DUT onto the mount M and air for floating the semiconductor device DUT from the mount M pass through.

As illustrated in Fig. 7, the second index table 12 is composed of a heat-resistant electrically insulating resin plate 121, a heater block 124, a ceramic plate 122, and a stage block 123 which are stacked in this order. As illustrated in Figs. 6 and 7, the stage block 123 has, on an upper surface thereof, depressed parts 123a each of which functions as the device placement region AD. In each of the depressed parts 123a, the mount M is put, and the semiconductor device DUT is placed on the mount M. The mount M is a plate-shaped member made of a material having thermal conductivity and electrical conductivity (for example, metal). Further, the stage block 123 has, therein, air supply and exhaust passages 123b. Each of the air supply and exhaust passages 123b is, on one side, open in a corresponding one of the depressed parts 123a and communicated with the through holes provided in the mount M. Each of the air supply and exhaust passages 123b is used as a flow passage through which air for sucking the semiconductor device DUT onto the mount M and air for floating the semiconductor device DUT from the mount M pass through.

The stage block 123 further has, on the upper surface thereof, depressed parts each of which functions as a mount placement region AM. In each of the depressed parts, a spare mount M' is put. A size and a material of the spare mount M' are identical to those of the mount M, and the mount M and the spare mount M' are replaceable with each other.

The heater block 124 embedded in the second index table 12 is used to heat the semiconductor device DUT placed in the device placement region AD. This makes it possible to test the semiconductor device DUT in the high-temperature environment without using an external heat source. The heater block 124 embedded in the second index table 12 is also used to heat the spare mount M' placed in the mount placement region AM. This makes it possible to keep the spare mount M' at a high temperature without using an external heat source. In other words, it is possible to replace the mount M with the spare mount M' without waiting for the spare mount M' to reach a high temperature, when it becomes necessary to replace the mount M with the spare mount M'.

### [Configuration of arm]

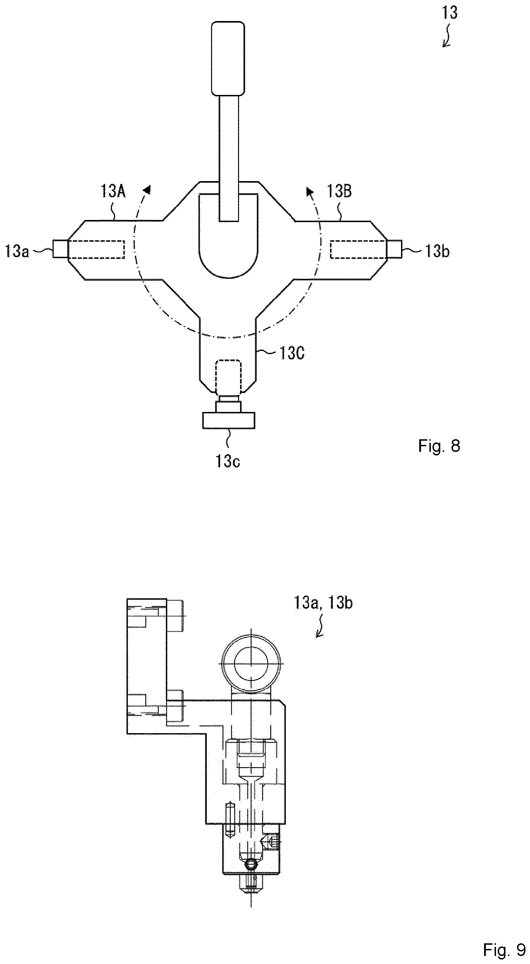

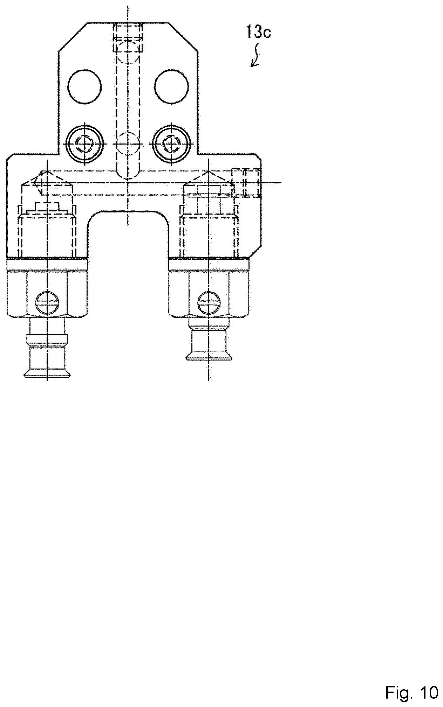

A configuration of the arm 13 included in the inspecting device 1 will be described with reference to Figs. 8 through 10. Fig. 8 is a plan view of the arm 13. Fig. 9 is a side view of each of the first and second device sucking heads 13a and 13b included in the arm 13. Fig. 10 is a side view of the mount sucking head 13c included in the arm 13.

As illustrated in Fig. 8, the arm 13 has a planar shape and is composed of three linear parts, that is, first through third linear parts 13A through 13C which are combined in the form of a letter "T". The first device sucking head 13a is attached to a back surface of an extreme end of the first linear part 13A which extends in a first direction from a rotation center of the arm 13. The second device sucking head 13b is attached to a back surface of an extreme end of the second linear part 13B which extends, from the rotation center of the arm 13, in a second direction that is an opposite direction from the first direction. The mount sucking head 13c is attached to a back surface of an extreme end of the third linear part 13C which extends, from the rotation center of the arm 13, in a third direction that is perpendicular to both of the first direction and the second direction.

As illustrated in Fig. 9, each of the first and second device sucking heads 13a and 13b has a structure suitable to suck the semiconductor device. As illustrated in Fig. 10, the mount sucking head 13c has a structure suitable to suck the mount. Each of the first and second device sucking heads 13a and 13b and the mount sucking head 13c can be a publicly known sucking pad. Therefore, the structure of each of the first and second device sucking heads 13a and 13b and the mount sucking head 13c will not be described in detail.

Note that the arm 13 can be alternatively configured in the form of a cross. In this case, it is possible to attach a further head to a back surface of an extreme end of a fourth linear part of the arm 13.

The further head can be, for example, a third device sucking head. In this case, it is considered to use the first device sucking head 13a and the second device sucking head 13b for the device transferring operation and use the third device sucking head for the device collecting operation. This makes it unnecessary to conduct the device transferring operation with use of the third device sucking head, which is likely to be damaged in the device collecting operation.

Alternatively, the further head can be, for example, an air blowing head. In this case, it is possible to, for example, remove, with use of air blown from the air blowing head, a foreign matter adhering to the mount.

### [Mount replacement method on first index table]

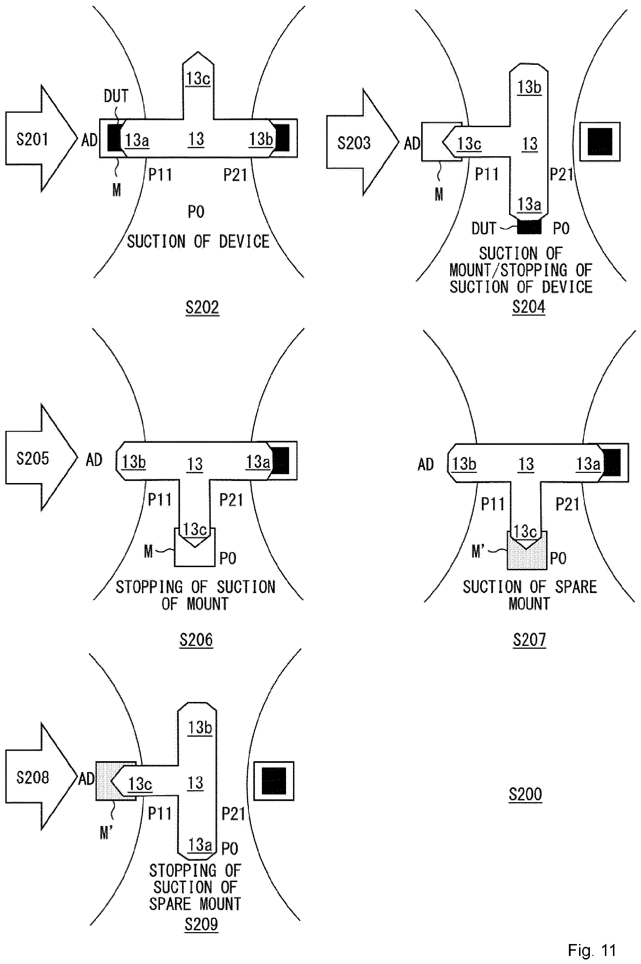

A case is assumed where the semiconductor device DUT, placed in the device placement region AD of the first index table 11 via the mount M, has been found to be a defective in any of the tests carried out in the room-temperature environment. The inspecting device 1 has a function of, in such a case, replacing the mount M with the spare mount M' supplied by the mount collecting and supplying unit 14. A flow of this mount replacement method S200 will be described with reference to Fig. 11. Fig. 11 is a schematic view illustrating a flow of the mount replacement method S200.

The mount replacement method S200 includes a rotation step S201, a device suction step S202, a rotation step S203, a mount suction/device suction stop step S204, a rotation step S205, a mount suction stop step S206, a spare mount suction step S207, a rotation step S208, and a spare mount suction stop step S209, as illustrated in Fig. 11. These steps S201 through S209 are carried out in a state where the device placement region AD is located at the third position P13 on the first within-table conveyance route P1.

The rotation step S201 is a step of rotating the arm 13 so that the first device sucking head 13a is located at the third position P13 on the first within-table conveyance route P1. In the mount replacement method carried out on the first index table, the third position P13 on the first within-table conveyance route P1 is an example of a "first position" in the Claims.

The device suction step S202 is a step of, at the third position P13 on the first within-table conveyance route P1, causing the first device sucking head 13a to suck the semiconductor device DUT.

The rotation step S203 is a step of rotating the arm 13 so that the first device sucking head 13a is located at a given position P0 and the mount sucking head 13c is located at the third position P13 on the first within-table conveyance route P1. In the mount replacement method carried out on the first index table, the given position P0 is an example of a "second position" in the Claims.

The mount suction/device suction stop step S204 is a step of (i) at the third position P13 on the first within-table conveyance route P1, causing the mount sucking head 13c to suck the mount M and (ii) at the given position P0, causing the first device sucking head 13a to stop sucking the semiconductor device DUT. Note that a device collection tray is disposed at the given position P0 and the semiconductor device DUT is held in the device collection tray.

The rotation step S205 is a step of rotating the arm 13 so that the mount sucking head 13c is located at the given position P0.

The mount suction stop step S206 is a step of, at the given position P0, causing the mount sucking head 13c to stop sucking the mount M. Note that the mount collecting and supplying unit 14 is disposed at the given position P0 and the mount M is collected by the mount collecting and supplying unit 14.

By the steps S201 through S206, the device collecting operation of collecting the semiconductor device DUT from the first index table 11 and the mount collecting operation of collecting the mount M from the first index table 11 are realized.

The spare mount suction step S207 is a step of, at the given position P0, causing the mount sucking head 13c to suck the spare mount M'. Note that the mount collecting and supplying unit 14 is disposed at the given position P0 and the spare mount M' is supplied by the mount collecting and supplying unit 14.

The rotation step S208 is a step of rotating the arm 13 so that the mount sucking head 13c is located at the third position P13 on the first within-table conveyance route P1.

The spare mount suction stop step S209 is a step of, at the third position P13 on the first within-table conveyance route P1, causing the mount sucking head 13c to stop sucking the spare mount M'.

By the steps S207 through S209, a spare mount putting operation of putting the spare mount M' on the first index table 11 is realized.

### [Mount replacement method on second index table]

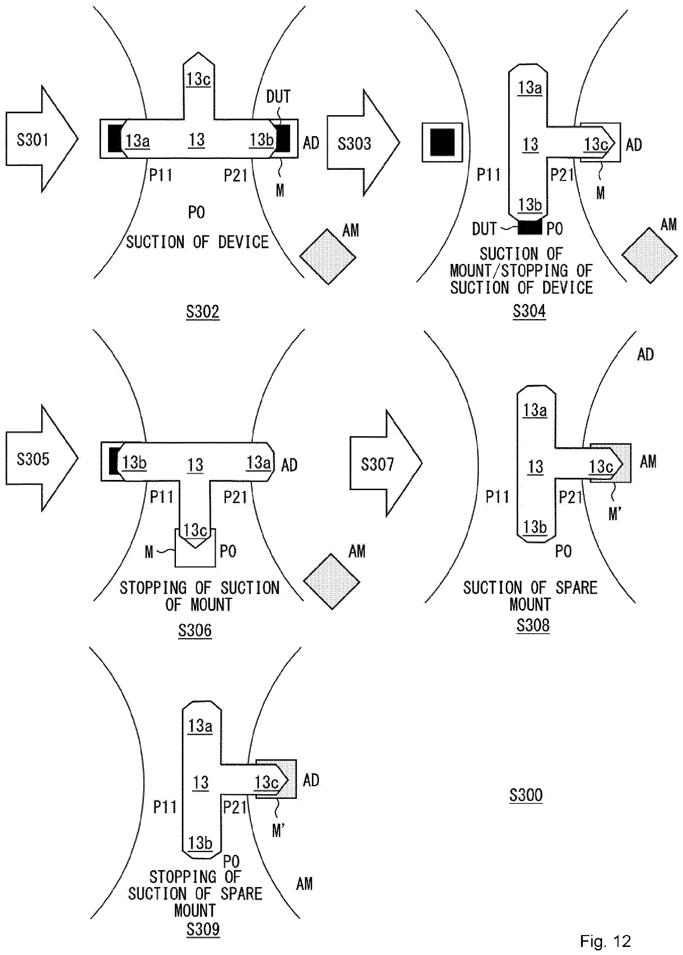

A case is assumed where the semiconductor device DUT, placed in the device placement region AD of the second index table 12 via the mount M, has been found to be a defective in any of the tests carried out in the high-temperature environment. The inspecting device 1 has a function of, in such a case, replacing the mount M with the spare mount M' placed in the mount placement region AM of the second index table 12. A flow of this mount replacement method S300 will be described with reference to Fig. 12. Fig. 12 is a schematic view illustrating a flow of the mount replacement method S300.

The mount replacement method S300 includes a rotation step S301, a device suction step S302, a rotation step S303, a mount suction/device suction stop step S304, a rotation step S305, a mount suction stop step S306, a rotation step S307, a spare mount suction step S308, and a spare mount suction stop step S309, as illustrated in Fig. 12. These steps S301 through S306 are carried out in a state where the device placement region AD is located at the first position P21 on the second within-table conveyance route P2.

The rotation step S301 is a step of rotating the arm 13 so that the second device sucking head 13b is located at the first position P21 on the second within-table conveyance route P2. In the mount replacement method carried out on the second index table, the first position P21 on the second within-table conveyance route P2 is an example of a "first position" in the Claims.

The device suction step S302 is a step of, at the first position P21 on the second within-table conveyance route P2, causing the second device sucking head 13b to suck the semiconductor device DUT.

The rotation step S303 is a step of rotating the arm 13 so that the second device sucking head 13b is located at the given position P0 and the mount sucking head 13c is located at the first position P21 on the second within-table conveyance route P2. In the mount replacement method carried out on the second index table, the given position P0 is an example of a "second position" in the Claims.

The mount suction/device suction stop step S304 is a step of (i) at the first position P21 on the second within-table conveyance route P2, causing the mount sucking head 13c to suck the mount M and (ii) at the given position P0, causing the second device sucking head 13b to stop sucking the semiconductor device DUT. Note that the device collection tray is disposed at the given position P0 and the semiconductor device DUT is held in the device collection tray.

The rotation step S305 is a step of rotating the arm 13 so that the mount sucking head 13c is located at the given position P0.

The mount suction stop step S306 is a step of, at the given position P0, causing the mount sucking head 13c to stop sucking the mount M. Note that the mount collecting and supplying unit 14 is disposed at the given position P0 and the mount M is collected by the mount collecting and supplying unit 14.

By the steps S301 through S306, the device collecting operation of collecting the semiconductor device DUT from the second index table 12 and the mount collecting operation of collecting the mount M from the second index table 12 are realized.

The rotation step S307 is a step of rotating the arm 13 so that the mount sucking head 13c is located at the first position P21 on the second within-table conveyance route P2.

The spare mount suction step S308 is a step of, at the first position P21 on the second within-table conveyance route P2, causing the mount sucking head 13c to suck the spare mount M'. The spare mount suction step S308 is carried out after a state is realized in which the mount placement region AM in which the spare mount M' is placed is located at the first position P21 on the second within-table conveyance route P2 by rotation of the second index table 12.

The spare mount suction stop step S309 is a step of, at the first position P21 on the second within-table conveyance route P2, causing the mount sucking head 13c to stop sucking the spare mount M'. The spare mount suction stop step S309 is carried out after a state is realized in which the device placement region AD in which the mount M was placed is located at the first position P21 on the second within-table conveyance route P2 by rotation of the second index table 12.

By the steps S307 through S309, the spare mount putting operation of putting the spare mount M' on the second index table 12 is realized.

### [Variation of inspecting device]

Note that although the configuration in which the dynamic characteristic test is carried out at the second position P12 on the first within-table conveyance route P1 and the static characteristic test is carried out at the fourth position P14 on the first within-table conveyance route P1 is employed in the present embodiment, the present invention is not limited to such a configuration. For example, a configuration in which the static characteristic test is carried out at the second position P12 on the first within-table conveyance route P1 and the dynamic characteristic test is carried out at the fourth position P14 on the first within-table conveyance route P1 can be alternatively employed. Note, however, that, according to the configuration in accordance with the present embodiment, the dynamic characteristic test is not carried out in the last place. Therefore, the configuration in accordance with the present embodiment has an advantage that it is possible to detect, by a subsequent test, a defect in the semiconductor device which defect has been caused by the dynamic characteristic test.

Note also that although the configuration in which the dynamic characteristic test is carried out at the second position P22 on the second within-table conveyance route P2 and the static characteristic test is carried out at the fourth position P24 on the second within-table conveyance route P2 is employed in the present embodiment, the present invention is not limited to such a configuration. For example, a configuration in which the static characteristic test is carried out at the second position P22 on the second within-table conveyance route P2 and the dynamic characteristic test is carried out at the fourth position P24 on the second within-table conveyance route P2 can be alternatively employed.

Note also that although the configuration in which the tests are carried out in the room-temperature environment on the first within-table conveyance route P1 and the tests are carried out in the high-temperature environment on the second within-table conveyance route P2 is employed in the present embodiment, the present invention is not limited to such a configuration. For example, a configuration in which the tests are carried out in the high-temperature environment on the first within-table conveyance route P1 and the tests are carried out in the room-temperature environment on the second within-table conveyance route P2 can be alternatively employed. Note, however, that, according to the configuration in accordance with the present embodiment, any of the tests is not carried out in the high-temperature environment in the last place. Therefore, the configuration in accordance with the present embodiment has an advantage that it is possible to detect, by a subsequent test, a defect in the semiconductor device which defect has been caused by any of such high-temperature tests.

Note also that although the configuration in which the tests are carried out at the respective positions P12 and P14 on the first within-table conveyance route P1 is employed in the present embodiment, the present invention is not limited to such a configuration. For example, a configuration in which the tests are carried out at a single position on the first within-table conveyance route P1 can be alternatively employed. Alternatively, a configuration in which tests are carried out at three or more positions on the first within-table conveyance route P1 can be employed. In this case, a test carried out at each of the three or more positions can be the static characteristic test, the dynamic characteristic test, or any other test.

Note also that although the configuration in which the tests are carried out at the respective positions P22 and P24 on the second within-table conveyance route P2 is employed in the present embodiment, the present invention is not limited to such a configuration. For example, a configuration in which the tests are carried out at a single position on the second within-table conveyance route P2 can be alternatively employed. Alternatively, a configuration in which tests are carried out at three or more positions on the second within-table conveyance route P2 can be employed. In this case, a test carried out at each of the three or more positions can be the static characteristic test, the dynamic characteristic test, or any other test.

Note also that although the configuration in which the inspecting device 1 includes two index tables, that is, the index tables 11 and 12 and a single arm, that is, the arm 13 is employed in the present embodiment, the present invention is not limited to such a configuration. That is, a configuration in which the inspecting device 1 includes N index tables and an N-1 arm(s), where N is any natural number of two or more, can be alternatively employed. In this case, an i-th arm is used to transfer the semiconductor device from an i-th index table to an i+1-th index table. Further, in this case, an environment of the tests carried out on one of adjacent index tables is different from that of the tests carried out on the other of the adjacent index tables. For example, in a case where the inspecting device 1 includes three index tables, the tests are carried out in a low-temperature environment on the first index table, the tests are carried out in the room-temperature environment on the second index table, and the tests are carried out in the high-temperature environment on the third index table. Alternatively, the tests are carried out in the room-temperature environment on the first index table, the tests are carried out in the high-temperature environment on the second index table, and the tests are carried out in the room-temperature environment on the third index table. Note that the semiconductor device can be transferred from an index table on which the tests are carried out in the room-temperature environment to an index table on which the tests are carried out in the high-temperature environment, by hand, instead of the arm.

Note also that although, in the present embodiment, the semiconductor device is inspected by the inspecting device 1, the present invention is not limited to the semiconductor device. Any device which needs to be tested in each of environments that are different in condition (in the present embodiment, environments that are different in temperature) can be an object to be inspected by the inspecting device 1.

### [Recap]

An inspecting device in accordance with the present invention is defined in appended claim 1.

According to the claimed invention, it is possible to handle a device and a mount with use of a single arm. Therefore, in regard to an inspecting device that includes an index table on which a device is placed via a replaceable mount, it is possible to simplify a mechanism for handling the device and the mount. This makes it possible to reduce a size and lower a cost of the inspecting device.

In a case where a device is found to be a defective in a test, a mount on which the device is placed may be damaged. According to the inspection device of claim 2, it is possible to carry out, with use of a single arm, (i) collection of the device which has been found to be a defective, (ii) collection of the mount on which the device has been placed, and (iii) putting of a new mount, each of which becomes necessary in such a case.

According to the inpsection device of claim 2, it is possible to efficiently carry out, with use of a single arm, (i) collection of a device which has been found to be a defective and (ii) collection of a mount on which the device has been placed.

According to the inspection device of claim 2, it is possible to efficiently carry out, with use of a single arm, putting of a spare mount.

According to the inspection device of claim 3, in an inspecting device which includes at least two index tables, it is possible to transfer a device between the at least two index tables with use of an arm configured to convey a device and a mount. Therefore, it is possible to simplify a configuration of the inspecting device which includes the at least two index tables.

According to the inspection device of claim 3, in an inspecting device which includes at least two index tables, it is possible to transfer a device between the least two index tables with use of an arm configured to convey a device and a mount. Therefore, it is possible to simplify a configuration of the inspecting device which includes the at least two index tables.

Furthermore, according to inpsection device of claim 3, it is possible to carry out, with use of different suction heads, (i) collection of a device which has been found to be a defective and (ii) transfer of a device between index tables. Therefore, it is possible to avoid transfer of damage to a normal device which transfer can occur in a case where a suction head damaged in collection of a device which has been found to be a defective is used to transfer the normal device between index tables.

According to the inspection device of claim 4, it is possible to realize, with a simple configuration, an inspecting device which has a function of removing a foreign matter adhering to a mount.

### Reference Signs List

- 1: Inspecting device
- 11: First index table
- 12: Second index table
- 13: Arm
- 14: Mount collecting and supplying unit
- 15: First testing device (for carrying out a dynamic characteristic test in a room-temperature environment)
- 16: Second testing device (for carrying out a dynamic characteristic test in a high-temperature environment)
- 17: Third testing device (for carrying out a static characteristic test in a high-temperature environment)
- 18: Fourth testing device (for carrying out a static characteristic test in a room-temperature environment)

## Claims

1. An inspecting device (1) for inspecting a device to be inspected, comprising:
- a first index table (11) having a first rotation axis;
- an arm (13) having a second rotation axis, the second rotation axis being parallel to the first rotation axis; and a mount (M) in which the device is placed and which is replaceable,
- the first index table (11) having a device placement region positioned on a first conveyance route (P1) which is circular and the center of which is the first rotation center and the first index table (11) rotating around the first rotation center to convey the device and the mount (M) along the first conveyance route,
- the device placement region being a region in which the device is to be placed via the mount (M),
- the arm (13) having a first linear part, a second linear part, a device sucking head (13a) and a mount sucking head (13c), the first linear part and the second linear part extending from a second rotation center in a first direction and a second direction different from the first direction, respectively, the device sucking head (13a) being attached to the first linear part and being configured to suck the device, the mount sucking head (13c) being attached to the second linear part and being configured to suck the mount (M), the first linear part and the second linear part being rotated around the second rotation center to convey the device and the mount (M) along a second conveyance route (P2),
- the first conveyance route and the second conveyance route overlapping each other at a first position,
- the mount (M) being able to be replaced by using the mount sucking head (13c).

2. The inspecting device (1) as set forth in claim 1, further comprising a mount supplying device (14) configured to supply a spare mount (M') at the second position, the mount supplying device overlapping the second conveyance route at a second position, wherein
- the arm (13) is configured to carry out (1) a device collecting operation of collecting the device from the device placement region with use of the device sucking head (13a), (2) a mount collecting operation of collecting the mount (M) from the device placement region with use of the mount sucking head (13c), and (3) a mount putting operation of putting the spare mount (M') in the device placement region with use of the mount sucking head (13c),
- the arm (13) is configured to be rotated so that the device sucking head (13a) is located at the first position in the device collecting operation and the mount collecting operation;
- the device sucking head (13a) is configured to suck the device at the first position while the device placement region is located at the first position in the device collecting operation and the mount collecting operation;
- the arm (13) is configured to be rotated so that the device sucking head (13a) is located at the second position and the mount sucking head (13c) is located at the first position in the device collecting operation and the mount collecting operation;
- the mount sucking head (13c) is configured to suck the mount (M) at the first position while the device placement region is located at the first position and the device sucking head (13a) is configured to stop sucking the device at the second position in the device collecting operation and the mount collecting operation;
- the arm (13) is configured to be rotated so that the mount sucking head (13c) is located at the second position in the device collecting operation and the mount collecting operation;
- the mount sucking head (13c) is configured to stop sucking the mount (M) at the second position in the device collecting operation and the mount collecting operation;
- the mount sucking head (13c) is configured to suck the spare mount (M') at the second position in the mount putting operation, the spare mount (M') being supplied by the mount supplying device;
- the arm (13) is configured to be rotated so that the mount sucking head (13c) is located at the first position in the mount putting operation; and
- the mount sucking head (13c) is configured to stop sucking the spare mount (M') at the first position while the device placement region is located at the first position in the mount putting.

3. The inspecting device (1) as set forth in claim 2, wherein:
- the inspecting device (1) further comprises a second index table (12) which has a third rotation axis, the third rotation axis being parallel to the first rotation axis, and which conveys the device and the mount (M) along a third conveyance route (P3) which is circular;
- the second conveyance route and the third conveyance route overlapping each other at a third position;
- in the arm (13), a direction in which the first linear part extends is perpendicular to a direction in which the second linear part extends;
- the arm (13) further has a third linear part which extends from the second rotation center in a third direction opposite to the first direction;
- when the device sucking head (13a) is considered as a first device sucking head (13a), the third linear part is provided with a second device sucking head (13b);
- the arm (13) transfers the device via the first position and the third position between the first index table (11) and the second index table (12);
- the device includes a first device and a second device; and
- the arm (13) is configured to carry out (a) a device transferring operation of, with use of the first and second device sucking heads (13a, 13b), concurrently (i) transferring the first device placed on one of the first and second index tables (11, 12) to the other of the first and second index tables (11, 12) and (ii) transferring the second device placed on the other of the first and second index tables (11, 12) to the one of the first and second index tables (11, 12) and (b) the device collecting operation with use of the first device sucking head (13a).

4. The inspecting device (1) as set forth in any one of claims 1 through 3, wherein the arm (13) further has an air blowing head configured to remove, by blowing air, a foreign matter adhering to the mount (M).

## Patentansprüche

1. Prüfvorrichtung (1) zum Prüfen einer zu prüfenden Vorrichtung, umfassend:
- einen ersten Indextisch (11) mit einer ersten Drehachse;
- einen Arm (13) mit einer zweiten Drehachse, wobei die zweite Drehachse parallel zur ersten Drehachse ist; und
- eine Befestigung (M), in der die Vorrichtung zu platzieren ist und die ersetzbar ist;
- wobei der erste Indextisch (11) eine Vorrichtungsplatzierungszone aufweist, die auf einem ersten Beförderungsweg (P1) positioniert ist, der kreisförmig ist und dessen Mittelpunkt der erste Drehmittelpunkt ist, und wobei sich der erste Indextisch (11) um den ersten Drehmittelpunkt dreht, um die Vorrichtung und die Befestigung (M) entlang des ersten Beförderungswegs zu befördern,
- wobei die Vorrichtungsplatzierungszone eine Zone ist, in der die Vorrichtung über die Befestigung (M) zu platzieren ist,
- wobei der Arm (13) einen ersten linearen Teil, einen zweiten linearen Teil, einen Vorrichtungssaugkopf (13a) und einen Befestigungssaugkopf (13c) aufweist, wobei sich der erste lineare Teil und der zweite lineare Teil jeweils von einem zweiten Drehmittelpunkt in einer ersten Richtung und einer zweiten Richtung, die von der ersten Richtung verschieden ist, erstrecken, wobei der Vorrichtungssaugkopf (13a) an dem ersten linearen Teil angebracht ist und eingerichtet ist, die Vorrichtung anzusaugen, wobei der Befestigungssaugkopf (13c) an dem zweiten linearen Teil angebracht ist und eingerichtet ist, die Befestigung (M) anzusaugen, wobei der erste lineare Teil und der zweite lineare Teil um den zweiten Drehmittelpunkt gedreht werden, um die Vorrichtung und die Befestigung (M) entlang eines zweiten Beförderungswegs (P2) zu befördern,
- wobei der erste Beförderungsweg und der zweite Beförderungsweg einander in einer ersten Position überlappen,
- wobei die Befestigung (M) unter Verwendung des Befestigungssaugkopfs (13c) ersetzt werden kann.

2. Prüfvorrichtung (1) nach Anspruch 1, ferner umfassend eine Befestigungszufuhrvorrichtung (14), die eingerichtet ist, eine Ersatzbefestigung (M') in der zweiten Position zuzuführen, wobei die Befestigungszufuhrvorrichtung den zweiten Beförderungsweg in einer zweiten Position überlappt, wobei
- der Arm (13) eingerichtet ist, durchzuführen (1) einen Vorrichtungsaufnahmevorgang zum Aufnehmen der Vorrichtung aus der Vorrichtungsplatzierungszone unter Verwendung des Vorrichtungssaugkopfs (13a), (2) einen Befestigungsaufnahmevorgang zum Aufnehmen der Befestigung (M) aus der Vorrichtungsplatzierungszone unter Verwendung des Befestigungssaugkopfs (13c), und (3) einen Befestigungssetzvorgang zum Setzen der Ersatzbefestigung (M') in die Vorrichtungsplatzierungszone unter Verwendung des Befestigungssaugkopfs (13c),
- der Arm (13) eingerichtet ist, gedreht zu werden, so dass der Vorrichtungssaugkopf (13a) in der ersten Position in dem Vorrichtungsaufnahmevorgang und dem Befestigungsaufnahmevorgang angeordnet ist;
- der Vorrichtungssaugkopf (13a) eingerichtet ist, die Vorrichtung in der ersten Position anzusaugen, während die Vorrichtungsplatzierungszone in der ersten Position in dem Vorrichtungsaufnahmevorgang und dem Befestigungsaufnahmevorgang angeordnet ist;
- der Arm (13) eingerichtet ist, gedreht zu werden, so dass der Vorrichtungssaugkopf (13a) in der zweiten Position angeordnet ist und der Befestigungssaugkopf (13c) in der ersten Position in dem Vorrichtungsaufnahmevorgang und dem Befestigungsaufnahmevorgang angeordnet ist;
- der Befestigungssaugkopf (13c) eingerichtet ist, die Befestigung (M) in der ersten Position anzusaugen, während die Vorrichtungsplatzierungszone in der ersten Position angeordnet ist, und der Vorrichtungssaugkopf (13a) eingerichtet ist, das Ansaugen der Vorrichtung in der zweiten Position in dem Vorrichtungsaufnahmevorgang und dem Befestigungsaufnahmevorgang zu stoppen;
- der Arm (13) eingerichtet ist, gedreht zu werden, so dass der Befestigungssaugkopf (13c) in der zweiten Position in dem Vorrichtungsaufnahmevorgang und dem Befestigungsaufnahmevorgang angeordnet ist;
- der Befestigungssaugkopf (13c) eingerichtet ist, das Ansaugen der Befestigung (M) in der zweiten Position in dem Vorrichtungsaufnahmevorgang und dem Befestigungsaufnahmevorgang zu stoppen;
- der Befestigungssaugkopf (13c) eingerichtet ist, die Ersatzbefestigung (M') in der zweiten Position in dem Befestigungsaufnahmevorgang anzusaugen, wobei die Ersatzbefestigung (M') von der Befestigungszufuhrvorrichtung zugeführt wird;
- der Arm (13) eingerichtet ist, gedreht zu werden, so dass der Befestigungssaugkopf (13c) in der ersten Position in dem Befestigungsaufnahmevorgang angeordnet ist; und
- der Befestigungssaugkopf (13c) eingerichtet ist, das Ansaugen der Ersatzbefestigung (M') in der ersten Position zu stoppen, während die Vorrichtungsplatzierungszone in der ersten Position beim Setzen der Befestigung angeordnet ist.

3. Prüfvorrichtung (1) nach Anspruch 2, wobei:
- die Prüfvorrichtung (1) ferner einen zweiten Indextisch (12) umfasst, der eine dritte Drehachse aufweist, wobei die dritte Drehachse parallel zu der ersten Drehachse ist, und der die Vorrichtung und die Befestigung (M) entlang eines dritten Beförderungswegs (P3) befördert, der kreisförmig ist;
- der zweite Beförderungsweg und der dritte Beförderungsweg einander an einer dritten Position überlappen;
- in dem Arm (13) eine Richtung, in der sich der erste lineare Teil erstreckt, senkrecht zu einer Richtung ist, in der sich der zweite lineare Teil erstreckt;
- der Arm (13) ferner einen dritten linearen Teil aufweist, der sich von dem zweiten Drehmittelpunkt in einer dritten Richtung entgegengesetzt zu der ersten Richtung erstreckt;
- wenn der Vorrichtungssaugkopf (13a) als ein erster Vorrichtungssaugkopf (13a) betrachtet wird, der dritte lineare Teil mit einem zweiten Vorrichtungssaugkopf (13b) versehen ist;
- der Arm (13) die Vorrichtung über die erste Position und die dritte Position zwischen dem ersten Indextisch (11) und dem zweiten Indextisch (12) überträgt;
- die Vorrichtung eine erste Vorrichtung und eine zweite Vorrichtung umfasst; und
- der Arm (13) eingerichtet ist, (a) einen Vorrichtungsübertragungsvorgang unter Verwendung des ersten und des zweiten Vorrichtungssaugkopfs (13a, 13b) auszuführen, gleichzeitig (i) die erste Vorrichtung, die auf einem von dem ersten und dem zweiten Indextisch (11, 12) platziert ist, zu dem anderen von dem ersten und dem zweiten Indextisch (11, 12) zu übertragen und (ii) die zweite Vorrichtung, die auf dem anderen von dem ersten und dem zweiten Indextisch (11, 12) platziert ist, zu dem einen von dem ersten und dem zweiten Indextisch (11, 12) zu übertragen, und (b) den Vorrichtungsaufnahmevorgang unter Verwendung des ersten Vorrichtungssaugkopfs (13a) auszuführen.

4. Prüfvorrichtung (1) nach einem der Ansprüche 1 bis 3, wobei der Arm (13) ferner einen Luftblaskopf aufweist, der eingerichtet ist, ein Fremdmaterial, das an der Befestigung (M) haftet, durch Blasen von Luft zu entfernen.

## Revendications

1. Dispositif d'inspection (1) pour l'inspection d'un dispositif à inspecter, comprenant :
- une première table d'indexage (11) présentant un premier axe de rotation ;
- un bras (13) présentant un deuxième axe de rotation, le deuxième axe de rotation étant parallèle au premier axe de rotation ; et
- une monture (M) dans laquelle le dispositif est placé et laquelle est remplaçable,
- la première table d'indexage (11) comportant une région de placement de dispositif positionnée sur un premier trajet de transport (P1), lequel est circulaire et dont le centre est le premier centre de rotation, et la première table d'indexage (11) tournant autour du premier centre de rotation pour transporter le dispositif et la monture (M) le long du premier trajet de transport,
- la région de placement de dispositif étant une région dans laquelle le dispositif doit être placé par le biais de la monture (M),
- le bras (13) comportant une première partie linéaire, une deuxième partie linéaire, une tête d'aspiration de dispositif (13a) et une tête d'aspiration de monture (13c), la première partie linéaire et la deuxième partie linéaire s'étendant à partir d'un deuxième centre de rotation dans une première direction et une deuxième direction différente de la première direction, respectivement, la tête d'aspiration de dispositif (13a) étant fixée à la première partie linéaire et configurée pour aspirer le dispositif, la tête d'aspiration de monture (13c) étant fixée à la deuxième partie linéaire et configurée pour aspirer la monture (M), la première partie linéaire et la deuxième partie linéaire étant mises en rotation autour du deuxième centre de rotation pour transporter le dispositif et la monture (M) le long d'un deuxième trajet de transport (P2),
- le premier trajet de transport et le deuxième trajet de transport se chevauchant à une première position,
- la monture (M) pouvant être remplacée à l'aide de la tête d'aspiration de monture (13c).

2. Dispositif d'inspection (1) selon la revendication 1, comprenant en outre un dispositif de fourniture de monture (14) configuré pour fournir une monture de rechange (M') à la deuxième position, le dispositif de fourniture de monture chevauchant le deuxième trajet de transport à une deuxième position, dans lequel
- le bras (13) est configuré pour exécuter (1) une opération de collecte de dispositif consistant à collecter le dispositif à partir de la région de placement de dispositif à l'aide de la tête d'aspiration de dispositif (13a), (2) une opération de collecte de monture comprenant collecter la monture (M) à partir de la région de placement de dispositif à l'aide de la tête d'aspiration de monture (13c), et (3) une opération de disposition de monture consistant à disposer la monture de rechange (M') dans la région de placement de dispositif à l'aide de la tête d'aspiration de monture (13c),
- le bras (13) est configuré pour être tourné de telle façon que la tête d'aspiration de dispositif (13a) se trouve à la première position dans l'opération de collecte de dispositif et l'opération de collecte de monture ;
- la tête d'aspiration de dispositif (13a) est configurée pour aspirer le dispositif à la première position tandis que la région de placement de dispositif se trouve à la première position dans l'opération de collecte de dispositif et l'opération de collecte de monture ;
- le bras (13) est configuré pour être tourné de telle façon que la tête d'aspiration de dispositif (13a) se trouve à la deuxième position et la tête d'aspiration de monture (13c) se trouve à la première position dans l'opération de collecte de dispositif et l'opération de collecte de monture ;
- la tête d'aspiration de monture (13c) est configurée pour aspirer la monture (M) à la première position tandis que la région de placement de dispositif se trouve à la première position et la tête d'aspiration de dispositif (13a) est configurée pour arrêter l'aspiration du dispositif à la deuxième position dans l'opération de collecte de dispositif et l'opération de collecte de monture ;
- le bras (12) est configuré pour être tourné de telle façon que la tête d'aspiration de monture (13c) se trouve à la deuxième position dans l'opération de collecte de dispositif et l'opération de collecte de monture ;
- la tête d'aspiration de monture (13c) est configurée pour arrêter l'aspiration de la monture (M) à la deuxième position dans l'opération de collecte de dispositif et l'opération de collecte de monture ;
- la tête d'aspiration de monture (13c) est configurée pour aspirer la monture de rechange (M') à la deuxième position dans l'opération de disposition de monture, la monture de rechange (M') étant fournie par le dispositif de fourniture de monture ;
- le bras (13) est configuré pour être tourné de telle façon que la tête d'aspiration de monture (13c) se trouve à la première position dans l'opération de disposition de monture ; et
- la tête d'aspiration de monture (13c) est configurée pour arrêter l'aspiration de la monture de rechange (M') à la première position tandis que la région de placement de dispositif se trouve à la première position dans l'opération de disposition de monture.

3. Dispositif d'inspection (1) selon la revendication 2, dans lequel :
- le dispositif d'inspection (1) comprend en outre une deuxième table d'indexage (12) qui a un troisième axe de rotation, le troisième axe de rotation étant parallèle au premier axe de rotation, et qui transporte le dispositif et la monture (M) le long d'un troisième trajet de transport (P3) qui est circulaire ;
- le deuxième trajet de transport et le troisième trajet de transport se chevauchant à une troisième position ;
- dans le bras (13), une direction dans laquelle la première partie linéaire s'étend est perpendiculaire à une direction dans laquelle la deuxième partie linéaire s'étend ;
- le bras (13) a en outre une troisième partie linéaire qui s'étend à partir du deuxième centre de rotation dans une troisième direction opposée à la première direction ;
- lorsque la tête d'aspiration de dispositif (13a) est considérée comme une première tête d'aspiration de dispositif (13a), la troisième partie linéaire est pourvue d'une deuxième tête d'aspiration de dispositif (13b) ;
- le bras (13) transfère le dispositif via la première position et la troisième position entre la première table d'indexage (11) et la deuxième table d'indexage (12) ;
- le dispositif comprend un premier dispositif et un deuxième dispositif ; et
- le bras (13) est configuré pour effectuer (a) une opération de transfert de dispositif comprenant, avec l'utilisation des première et deuxième têtes d'aspiration de dispositif (13a, 13b), simultanément (i) transférer le premier dispositif placé sur l'une des première et deuxième tables d'indexage (11, 12) à l'autre des première et deuxième tables d'indexage (11, 12) et (ii) transférer le deuxième dispositif placé sur l'autre des première et deuxième tables d'indexage (11, 12) à l'une des première et deuxième tables d'indexage (11, 12) et (b) l'opération de collecte de dispositif avec l'utilisation de la première tête d'aspiration de dispositif (13a).

4. Dispositif d'inspection (1) selon l'une quelconque des revendications 1 à 3, dans lequel le bras (13) a en outre une tête de soufflage d'air configurée pour éliminer, par soufflage d'air, une matière étrangère adhérant à la monture (M).
